# EUROPEAN PATENT SPECIFICATION

(11) **EP 0 484 286 B1**
(45) Date of publication and mention of the grant of the patent: **11.10.1995**
(21) Application number: 91830446.0
(22) Date of filing: 22.10.1991
(51) Int. Cl.: H05K 7/10

(54) **An electronic device including an integrated circuit mounted on an insulating base**
Eine elektronische Vorrichtung mit einer auf einem isolierten Aufbau sitzenden integrierten Schaltung
Dispositif électronique comprenant un circuit intégré monté sur une base isolante

(30) Priority: 30.10.1990 IT 5334890 U
(43) Date of publication of application: 06.05.1992
(73) Proprietor: MAGNETI MARELLI S.p.A., 20145 Milano (IT)
(72) Inventor: Bertoldo, Walter, I-10042 Nichelino (Torino) (IT)
(74) Representative: Quinterno, Giuseppe

(56) References cited:
- WO-A-88/06395
- US-A- 4 226 492
- US-A- 4 677 526

## Description

The present invention relates to an electronic device including an integrated circuit carried by an insulating base, for example, a circuit for regulating the voltage supplied by a motor-vehicle alternator in operation.

More specifically, the invention is directed towards an electronic device which includes an integrated circuit encapsulated in a casing and having a plurality of electrical pin terminals which extend from one face of the casing, the integrated circuit being mounted on a support plate or base of electrically insulating material carrying conductive connecting members which are connected to the terminals of the circuit.

The device according to the invention is characterised in that:
- the support plate or base is moulded from a plastics material and has a hole in the region in which the integrated circuit is mounted,
- the conductive connecting members are at least partially embedded in the plate or base and have respective free ends in the hole in relative positions substantially corresponding to those of the terminals of the integrated circuit, the free ends of all the conductive members being bent in the same direction towards the face of the plate or base opposite that bearing the integrated circuit so as to be at least partially in contact with the corresponding terminals of the integrated circuit.

According to a further characteristic, conveniently, the free ends of the conductive members extend in the hole in the support plate or base outwardly of the corresponding terminals of the integrated circuit and are bent in a manner such that when the integrated circuit is mounted on the plate or base, the terminals of the circuit fit with interference between the ends of the conductive members.

To advantage, the end portion of the free end of each conductive member forms a loop which, when the integrated circuit is in the mounted condition, faces and is in contact with the associated terminal of the integrated circuit.

Preferably, the free ends of the conductive members are soldered to the associated terminals of the integrated circuit in correspondence with their respective loops.

Further characteristics and advantages of the invention will become clear from the detailed description which follows with reference to the appended drawings, provided purely by way of non-limiting example, in which:
Figure 1 is a perspective view of a device according to the invention, and
Figure 2 is a partial sectional view taken on the line II-II of Figure 1, on an enlarged scale.

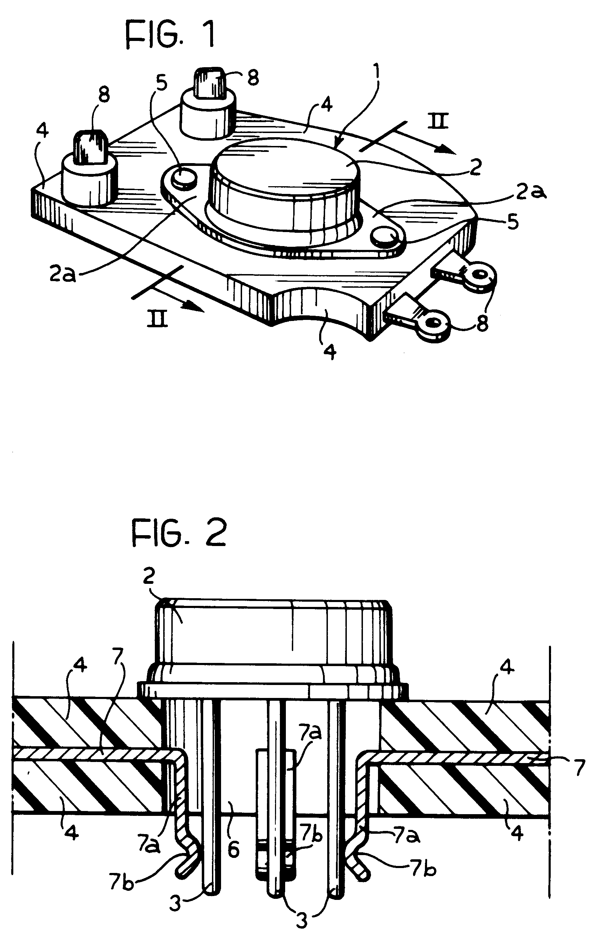

With reference to Figure 1, an electronic device according to the invention includes an integrated circuit 1, for example, a voltage-regulator circuit for a motor-vehicle alternator, encapsulated in a casing 2 and having a plurality of metal pin terminals 3 which extend from one face of the casing. In the embodiment shown by way of example, the casing of the integrated circuit is of a standard type known by the reference TO3 and has two flanges 2a which are fixed to a plate or base 4 of electrically insulating material, for example, by metal rivets 5.

Conveniently, the support plate or base 4 is moulded from a plastics material and has a hole 6 (Figure 2) in the region in which the integrated circuit 1 is mounted.

Conductive connecting members, indicated 7, of which three are partly visible in Figure 2, are incorporated in the plate or base 4 at the moulding stage. The conductive members have first ends which project from the plate or base 4 to form connecting terminals, indicated 8 in Figure 1, which in general may be of many different shapes.

The conductive members 7 embedded in the support plate or base 4 have further ends, indicated 7a in Figure 2, in the hole 6 in relative positions substantially corresponding to those of the terminals 3 of the integrated circuit 1. The ends 7a of all the conductive members are bent in the same direction, towards the face of the plate or base 4 opposite that bearing the integrated circuit. In particular, these ends are bent in a manner such that when the integrated circuit 1 is mounted on the plate 4, the terminals 3 of the circuit fit with resilient interference between the ends 7a of the conductive members 7.

Conveniently, the end portion of the end 7a of each conductive member 7 forms a loop, indicated 7b in Figure 2, which, when the integrated circuit 1 is in the mounted condition, faces and is in contact with an associated terminal 3 of the integrated circuit. The ends 7a of the conductive members 7 are then preferably soldered (for example, by electrical soldering) to the terminals 3 of the integrated circuit in correspondence with the loops 7b.

The invention enables an integrated circuit to be mounted quickly and easily on a support plate or base in a particularly reliable and secure manner.

## Claims

1. An electronic device including an integrated circuit (1) encapsulated in a casing (2) and having a plurality of metal pin terminals (3) which extend from one face of the casing (2), the integrated circuit (1) being mounted on a support plate or base (4) of electrically insulating material carrying conductive connecting members (7) which are connected to the terminals (3) of the circuit (1),
characterised in that:
- the support plate or base (4) is moulded from a plastics material and has a hole (6) in the region in which the integrated circuit (1) is mounted,
- the conductive connecting members (7) are at least partially embedded in the plate or base (4) and have respective free ends (7a) in the hole (6) in relative positions substantially corresponding to those of the terminals (3) of the integrated circuit (1), the free ends (7a) of all the conductive members (7) being bent in the same direction towards the face of the plate or base (4) opposite that bearing the integrated circuit (1) so as to be at least partially in contact with the corresponding terminals (3) of the integrated circuit (1).

2. A device according to Claim 1, characterised in that the free ends (7a) of the conductive members (7) extend in the hole (6) outwardly of the corresponding terminals (3) of the integrated circuit (1) and are bent in a manner such that when the integrated circuit (1) is mounted on the support plate or base (4), the terminals (3) of the integrated circuit (1) fit with interference between the ends (7a) of the conductive members (7).

3. A device according to Claim 2, characterised in that the end portion of the free end (7a) of each conductive member (7) forms a loop (7b) which, when the integrated circuit (1) is in the mounted condition, faces and is in contact with an associated terminal (3) of the integrated circuit (1).

4. A device according to Claim 3, characterised in that the free ends (7a) of the conductive members (7) are soldered to the associated terminals (3) of the integrated circuit (1) in correspondence with their respective loops (7b).

## Patentansprüche

1. Elektronische Vorrichtung mit einer in einem Gehäuse (2) eingehüllten integrierten Schaltung (1), die eine Vielzahl metallischer Stiftanschlüsse (3) hat, die von einer Fläche des Gehäuses (2) ausgehen, wobei die integrierte Schaltung (1) auf einer Trägerplatte oder Basis (4) aus elektrisch isoliertem Material montiert ist, die leitende Verbindungsglieder (7) trägt, die mit den Anschlüssen (3) der Schaltung (1) verbunden sind,
**dadurch gekennzeichnet**, daß
- die Trägerplatte oder Basis (4) aus plastischem Material geformt ist und ein Loch (6) im Bereich hat, auf dem die integrierte Schaltung (1) montiert ist,
- die leitenden Verbindungsglieder (7) wenigstens teilweise in der Platte oder Basis (4) eingebettet sind und jeweils freie Enden (7a) im Loch (6) in relativen Positionen im wesentlichen entsprechend denjenigen der Anschlüsse (3) der integrierten Schaltung (1) haben, wobei die freien Enden (7a) aller leitender Glieder (7) in gleicher Richtung gegen die Fläche der Platte oder Basis (4) abgewinkelt sind, die der die integrierte Schaltung (1) tragenden Fläche entgegengesetzt ist, um wenigstens teilweise in Kontakt mit den entsprechenden Anschlüssen (3) der integrierten Schaltung (1) zu sein.

2. Vorrichtung nach Anspruch 1,
**dadurch gekennzeichnet,**
daß die freien Enden (7a) der leitenden Glieder (7) im Loch (6) außen an den entsprechenden Anschlüssen (3) der integrierten Schaltung (1) verlaufen und in der Art abgewinkelt sind, daß bei auf der Trägerplatte oder Basis (4) montierter integrierter Schaltung (1) die Anschlüsse (3) der integrierten Schaltung mit Überlagerung zwischen die Enden (7a) der leitenden Glieder (7) passen.

3. Vorrichtung nach Anspruch 2,
**dadurch gekennzeichnet,**
daß der Endabschnitt des freien Endes (7a) jedes leitenden Glieds (7) einen Bügel (7b) bildet, der in montierter Stellung der integrierten Schaltung (1) einen zugeordneten Anschluß (3) der integrierten Schaltung (1) gegenübersteht und in Kontakt mit diesem steht.

4. Vorrichtung nach Anspruch 3,
**dadurch gekennzeichnet,**
daß die freien Enden (7a) der leitenden Glieder (7) an die zugeordneten Anschlüsse (3) der integrierten Schaltung (1) in Übereinstimmung mit ihren jeweiligen Bügeln (7b) angelötet sind.

## Revendications

1. Dispositif électronique comprenant un circuit intégré (1) encapsulé dans un boîtier (2) et ayant une pluralité de bornes électriques (3) à fiches qui s'étendent à partir d'une face du boîtier (2), le circuit intégré (1) étant monté sur une plaque de support ou une base (4) d'un matériau électriquement isolant portant des éléments conducteurs de connexion (7) connectés aux bornes (3) du circuit (1), caractérisé en ce que :
- la plaque de support ou la base (4) est moulée en matière plastique et comporte un orifice (6) dans la zone dans laquelle le circuit intégré (1) est monté,
- les éléments conducteurs de connexion (7) sont au moins partiellement incrustés dans la plaque ou la base (4) et possèdent des extrémités libres (7a) dans le trou (6) en des positions relatives correspondant sensiblement à celles des bornes (3) du circuit intégré (1), les extrémités libres (7a) de tous les éléments conducteurs (7) étant incurvées dans la même direction, vers la face de la plaque ou de la base (4) qui est opposée à celle portant le circuit intégré (1) de manière à être, au moins partiellement, en contact avec les bornes correspondantes (3) du circuit intégré (1).

2. Dispositif selon la revendication 1, caractérisé en ce que les extrémités libres (7a) des éléments conducteurs (7) s'étendent dans l'orifice (6) vers l'extérieur des bornes correspondantes (3) du circuit intégré (1) et sont incurvées de manière telle que lorsque le circuit intégré (1) est monté sur la plaque de support ou la base (4), les bornes (3) du circuit intégré (1) s'insèrent en conjonction entre les extrémités (7a) des éléments conducteurs (7).

3. Dispositif selon la revendication 2, caractérisé en ce que la partie d'extrémité de l'extrémité libre (7a) de chaque élément conducteur (7) forme une boucle (7b) qui, lorsque le circuit intégré (1) est en condition montée, fait face à, et est en contact avec, une borne associée (3) du circuit intégré (1).

4. Dispositif selon la revendication 3, caractérisé en ce que les extrémités libres (7a) des éléments conducteurs (7) sont soudées aux bornes associées (3) du circuit intégré (1) en correspondance avec leurs boucles respectives (7b).
